# EUROPEAN PATENT SPECIFICATION

(11) **EP 2 653 797 B1**
(45) Date of publication and mention of the grant of the patent: **29.11.2017**
(21) Application number: 10860771.4
(22) Date of filing: 15.12.2010
(51) Int. Cl.: F24F 11/053, F24F 13/10, H05K 7/20

(54) **AIR-CONDITIONING CONTROL SYSTEM WITH AIRFLOW ADJUSTMENT DEVICE**
KLIMAANLAGENSTEUERUNGSSYSTEM MIT LUFTSTROMEINSTELLUNGSVORRICHTUNG
SYSTÈME DE COMMANDE DE CLIMATISATION AVEC DISPOSITIF DE RÉGLAGE D'ÉCOULEMENT D'AIR

(43) Date of publication of application: 23.10.2013
(73) Proprietor: Fujitsu Limited, Kawasaki-shi, Kanagawa 211-8588 (JP)
(72) Inventor: UNO, Kazushi, Kawasaki-shi Kanagawa 211-8588 (JP); TAKEI, Fumio, Kawasaki-shi Kanagawa 211-8588 (JP); KASAJIMA, Takeo, Kawasaki-shi Kanagawa 211-8588 (JP); KASHIKAWA, Takahiro, Kawasaki-shi Kanagawa 211-8588 (JP); ISHINABE, Minoru, Kawasaki-shi Kanagawa 211-8588 (JP); TADAKI, Kyouko, Kawasaki-shi Kanagawa 211-8588 (JP)
(74) Representative: Wilding, Frances Ward
(86) International application number: PCT/JP2010/072551
(87) International publication number: WO 2012/081092

(56) References cited:
- WO-A1-2010/125712
- DE-U1-202004 009 352
- JP-A- 2004 126 968
- JP-A- 2005 196 342
- JP-A- 2008 002 690
- JP-A- 2010 230 210
- JP-U- H0 277 537
- JP-U- H01 175 256
- US-A- 5 160 115
- US-B1- 6 183 359
- US-B1- 6 694 759

## Description

### TECHNICAL FIELD

The present invention relates to an air-conditioning control system and an air volume adjustment device.

### BACKGROUND ART

In recent years, a large quantity of data are handled by computers with the advent of an advanced information society and a large number of computers are often installed in one room and managed in a centralized manner. In a data center, for example, a large number of racks (server racks) are installed in a computer room and a plurality of computers (servers) are housed in each rack. Then, a large amount of jobs are organically distributed to and efficiently processed by the computers.

In general, a computer of a rack-mounted type (a type designed to be housed in a rack) takes in the air in a room from one surface side of a rack to cool a CPU (central processing unit) and the like, and discharges the air raised to a high temperature as a consequence from another surface side of the rack. An increase in temperature in the room where the computers are installed may cause a failure or a malfunction of a computer. Accordingly, in a data center, the temperature in the computer room is managed by an air conditioner so that temperatures of the computers may not exceed an allowable temperature.

The amount of power consumption required for air conditioning in a data center is said to be as large as the total power consumption by computers. For this reason, reduction in the power required for the air conditioning is desired.

Meanwhile, a performance improvement of a CPU, an introduction of 64-bit OS (operating system), a capacity increase of a hard disk drive, and the like are enabling a single computer (a physical server) to run with a plurality of virtual machines (VM) loaded thereon. Accordingly, so-called VM consolidation/deployment techniques have been developed and are being gradually put into practical use. In the VM consolidation/deployment techniques, virtual machines in a plurality of computers (physical servers) with low CPU utilization are consolidated into one computer and the computers thus turned into an idle state are temporarily turned off.

A rack-mounted computer consumes power of about 100 W even in an idle state. Accordingly, it is possible to drastically reduce the power consumption in the data center by turning off the computers turned into the idle state by use of the VM consolidation/deployment techniques.

Patent Document 4 discloses controlling cooling fluid pressure within a plenum of a cooling system by activating the cooling system, sensing pressure within the plenum in at least one zone of the data center, determining whether the pressure is within a predetermined pressure range, and modulating at least one of a plurality of automatically adjustable vents in response to the pressure being outside the predetermined pressure, thereby adjusting the velocity and the volume flow rate of the cooling fluid therethrough.

### PRIOR ART DOCUMENTS

### PATENT DOCUMENTS

Patent Document 1: Japanese Laid-open Patent Publication No. 2009-299919
Patent Document 2: Japanese Laid-open Patent Publication No. 2010-32174
Patent Document 3: Japanese Laid-open Patent Publication No. 2006-64283
Patent Document 4: US6694759B1

### SUMMARY OF THE INVENTION

### PROBLEM TO BE SOLVED BY THE INVENTION

However, there is a demand to further reduce power consumption in a data center from the standpoint of energy saving and prevention of global warming.

In view of the above, an object is to provide an air-conditioning control system and an air volume adjustment device, which can further reduce power consumption in a facility such as a data center.

### MEANS FOR SOLVING THE PROBLEM

The invention is defined in the independent claim. Optional embodiments are set out in the dependent claims.

### EFFECTS OF THE INVENTION

In the air-conditioning control system according to the above-described aspect, the air volume adjustment device is located at the vent for connecting the free access floor to the equipment installation area. The air volume adjustment device includes the first roll, the second roll, and the air volume adjustment sheet. Moreover, the volume of the air flowing from the free access floor to the equipment installation area through the vent can be adjusted by changing a portion of the air volume adjustment sheet to be located between the first roll and the second roll. Thus, the volume of the air to be supplied through the vent to the equipment installation area can be adjusted depending on amounts of heat generated by the computers, so that the computers can be cooled efficiently. As a consequence, the power consumption in a facility such as a data center is reduced.

### BRIEF DESCRIPTION OF THE DRAWINGS

[Fig. 1]

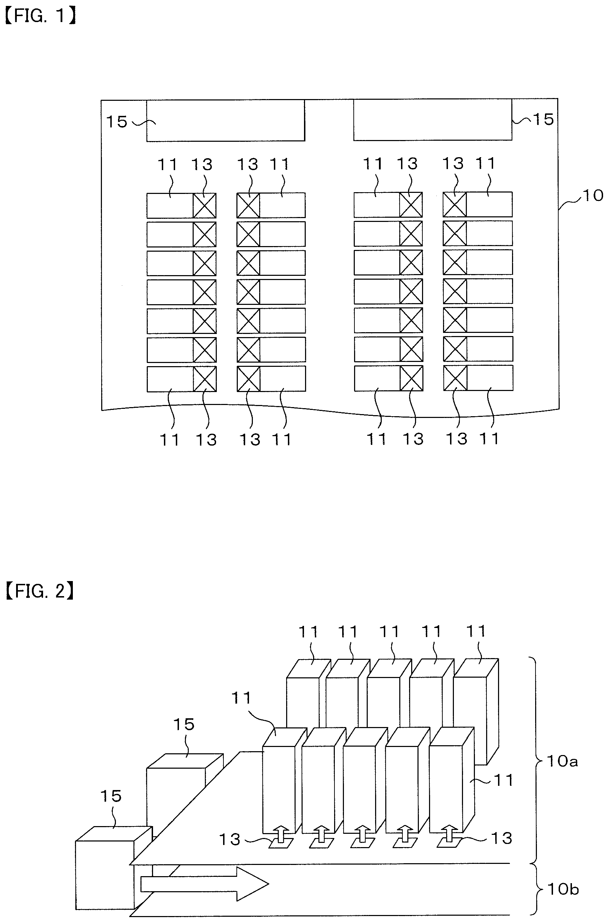

   Fig. 1 is a plan view explaining an example of a computer room.
[Fig. 2]
   Fig. 2 is a schematic perspective view of the computer room.
[Fig. 3]

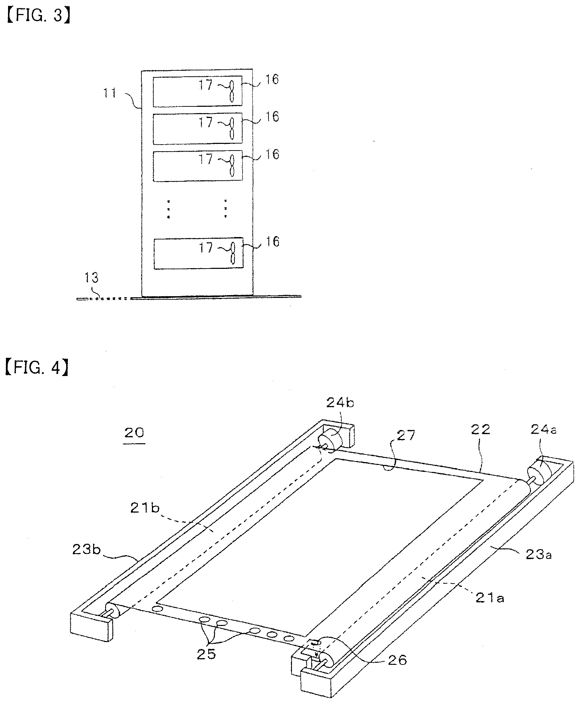

   Fig. 3 is a schematic diagram of a state where computers are housed in a rack.
[Fig. 4]
   Fig. 4 is a perspective view (part 1) exemplifying an air volume adjustment device according to an embodiment.
[Fig. 5]

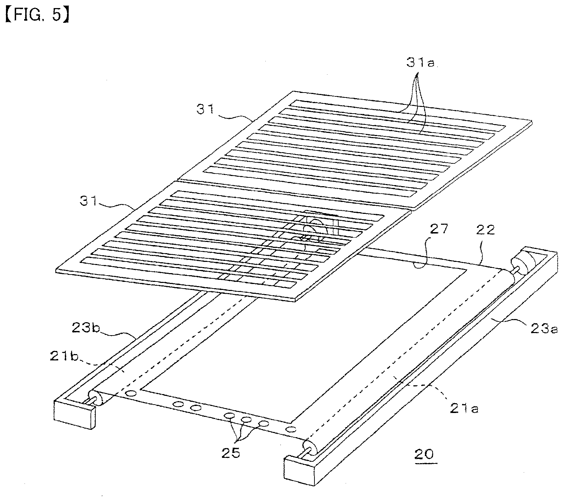

   Fig. 5 is a perspective view (part 2) exemplifying the air volume adjustment device according to the embodiment.
[Fig. 6]

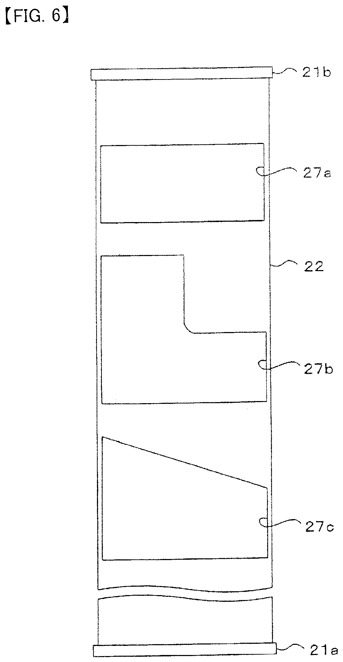

   Fig. 6 is a development view exemplifying an air volume adjustment sheet (part 1) provided with a plurality of opening patterns (openings).
[Fig. 7]

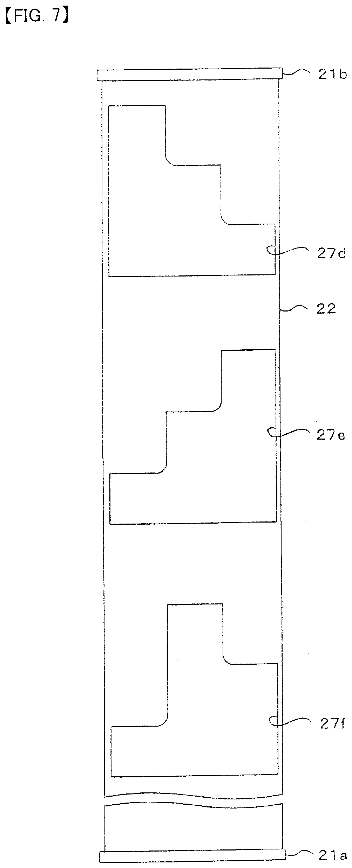

   Fig. 7 is a development view exemplifying an air volume adjustment sheet (part 2) provided with a plurality of opening patterns (openings).
[Fig. 8]

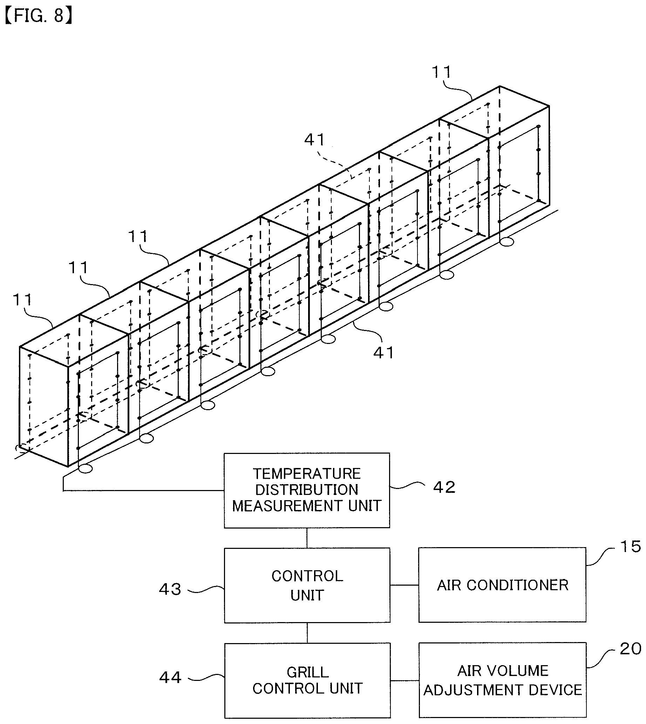

   Fig. 8 is a schematic diagram exemplifying a first air-conditioning control system.
[Fig. 9]

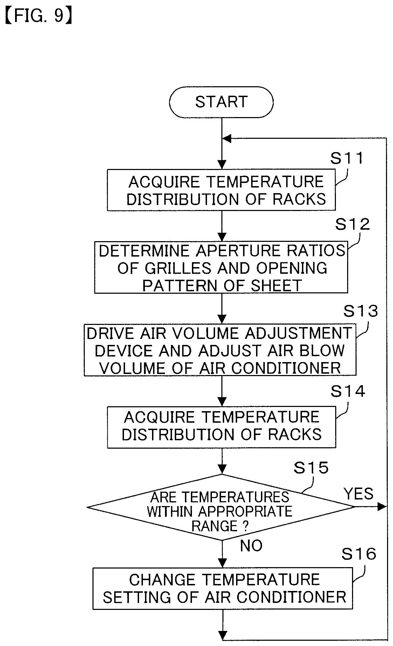

   Fig. 9 is a flowchart exemplifying operations of the first air-conditioning control system.
[Fig. 10]

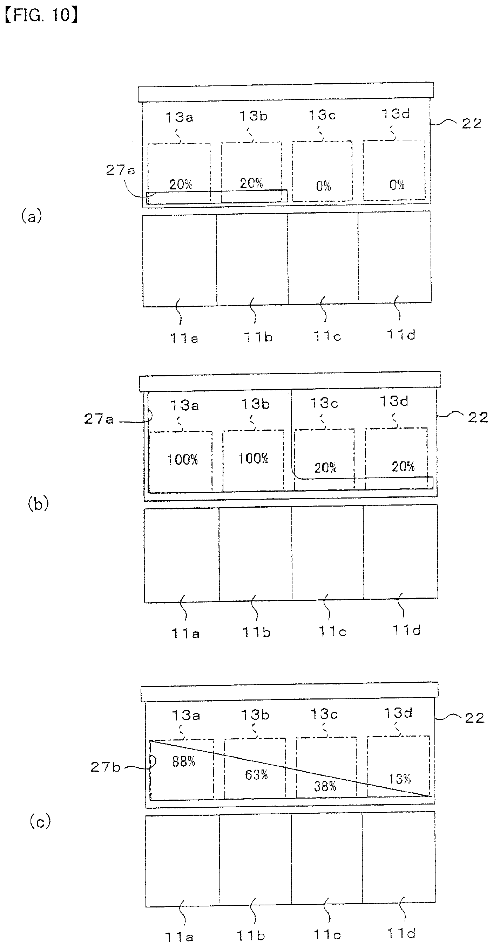

   Fig. 10 is a schematic diagram exemplifying the operations of the first air-conditioning control system.
[Fig. 11]

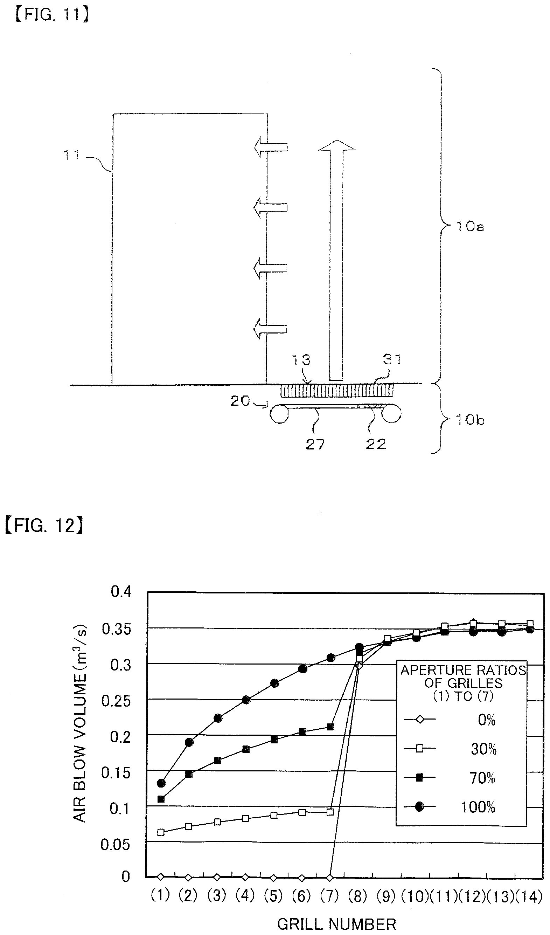

   Fig. 11 is a schematic diagram illustrating a flow of air from a grille to a rack.
[Fig. 12]
   Fig. 12 is a view illustrating a simulation result of relations between aperture ratios of the grilles and volumes of air blowing out of the grilles.
[Fig. 13]

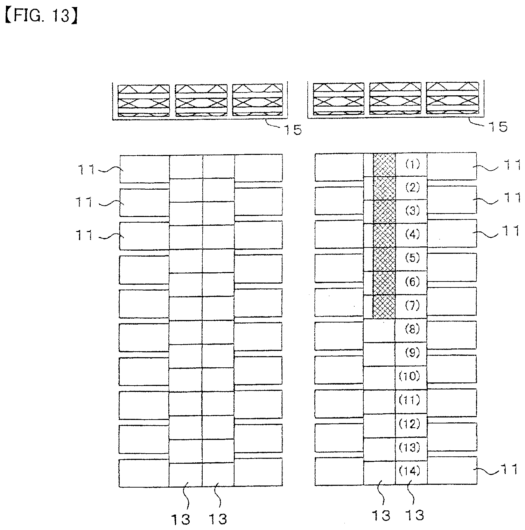

   Fig. 13 is a schematic diagram illustrating a layout inside a computer room at the time of simulation calculation.
[Fig. 14]

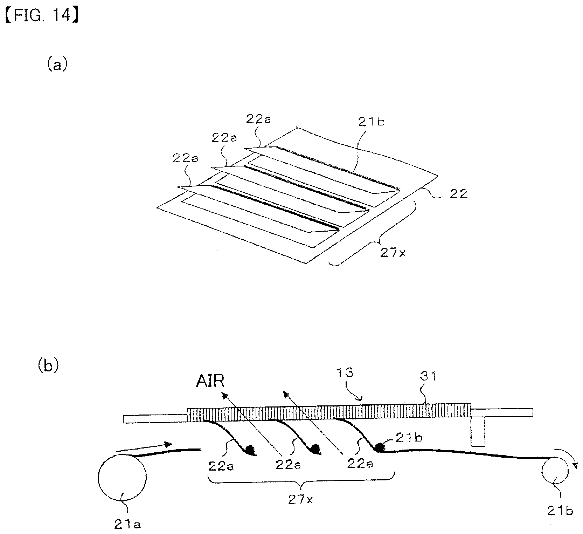

   Fig. 14(a) is a perspective view explaining another example of an opening pattern provided to an air volume adjustment sheet, and Fig. 14(b) is a schematic diagram illustrating a state where the air volume adjustment sheet is located near a grille.
[Fig. 15]

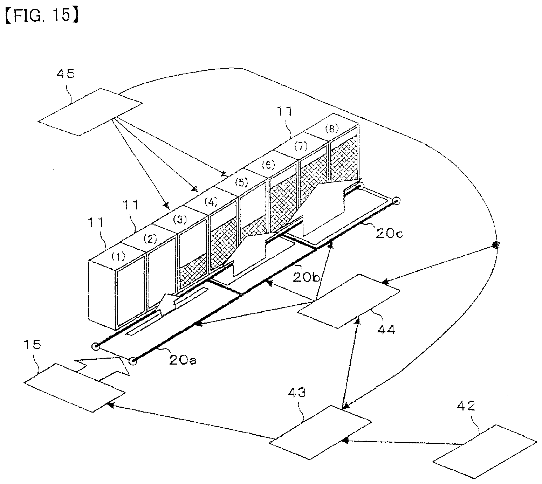

   Fig. 15 is a schematic diagram exemplifying a second air-conditioning control system.

### MODES FOR CARRYING OUT THE INVENTION

Prior to descriptions of embodiments, a prelude for facilitating understandings of the embodiments will be described below.

Fig. 1 is a plan view explaining an example of a computer room. Fig. 2 is a schematic perspective view of the same computer room. Fig. 3 is a schematic diagram of a state where computers are housed in a rack.

As in Fig. 2, a computer room 10 includes an equipment installation area 10a where racks (server racks) 11 are installed, and a free access floor (an underfloor space) 10b provided below a floor of the equipment installation area 10 and used to place power cables, communication cables, and the like.

As in Fig. 1, a large number of racks 11 are installed side by side in rows in the equipment installation area 10a. Meanwhile, as in Fig. 3, a plurality of computers (physical servers) 16 are vertically arranged and housed in each rack 11.

Each computer 16 is provided with a cooling fan 17. The cooling fan 17 is configured to take in air from a front surface (hereinafter referred to as an "intake surface") side of the rack 11 while rotating at the number of revolutions corresponding to a temperature of a CPU, for example, and discharge the air heated to a high temperature as a consequence of cooling the CPU from a back surface (hereinafter referred to as an "exhaust surface") side.

The racks 11 in adjacent rows are arranged in such a way that their intake surfaces or exhaust surfaces are opposed to each other. Grilles (vents) 13 to connect the free access floor 10b to the equipment installation area 10a are provided on the floor of an aisle on the intake surface side for each one or a plurality of racks 11.

Meanwhile, one or a plurality of air conditioners 15 are installed in the computer room 10. The air conditioner 15 is configured to take in the air from the equipment installation area 10a and supply the air adjusted to a low temperature to the free access floor 10b. The low-temperature air is sent out to the equipment installation area 10a through the grilles 13 and is taken into the racks 11 from the intake surface side. Then, the air (exhaust air) at an increased temperature after cooling the computers 16 in the racks 11 is discharged from the exhaust side of the racks 11 to the equipment installation area 10a.

In the computer room 10 illustrated in Fig. 1 and Fig. 2, the racks in adjacent rows are arranged in such a way that intake surfaces or exhaust surfaces of the racks 11 in the adjacent rows are opposed to each other. In this way, an area where the low-temperature air is supplied through the grilles 13 and an area where the high-temperature air is discharged from the racks 11 are spatially separated, whereby efficient cooling of the racks 11 is enabled. In the following, the area on the intake surface side of the racks where the low-temperature air is supplied will be referred to as a cold aisle and the area on the exhaust surface side of the racks where the high-temperature air is discharged will be referred to as a hot aisle.

The air inside the computer room 10 circulates in the following order: the air conditioners 15; the free access floor 10b; the equipment installation area 10a (the cold aisles); the racks 11; the equipment installation area 10a (the hot aisles); and the air conditioners 15.

In the meantime, the CPU utilization of a computer 16 varies depending on submitted jobs, and a computer 16 to which a large quantity of jobs are submitted or a computer 16 to which heavy load jobs are submitted generates a large amount of heat along with processing such jobs. On the other hand, the low-temperature air sent out of the air conditioners 15 is supplied substantially evenly to the racks 11 through the grilles 13. For this reason, insufficient cooling may occur locally if the temperature inside the computer room 10 is simply adjusted by the air conditioners 15.

For instance, it is possible to resolve the local insufficient cooling by employing an air conditioner having a large cooling capacity and operating the air conditioner always at its full capacity. However, a problem of an increase in the power required for the air conditioning arises in that case. For this reason, the efficient air conditioning in the computer room 10 is expected.

In order to realize the efficient cooling inside the computer room 10, there has been a proposal to cool a rack 11 having a large amount of heat generation (a sum of amounts of heat generated by the computers housed therein) locally by using a local cooling device separately from the air conditioners 15. However, in this case, an effect of reducing the power required for the air conditioning cannot be sufficiently obtained not only because it is necessary to bear costs associated with installation of the local cooling device but also because power consumption by the local cooling device is relatively high.

Meanwhile, one conceivable solution is that the volume of the low-temperature air to be supplied from the free access floor 10b to the equipment installation area 10a is adjusted for each grille 13. Specifically, the volume of the air supplied from each grille 13 is dynamically changed in such a manner as to increase the volume of the air supplied from the grille 13 to the rack 11 having a large amount of heat generation and to decrease the volume of the air supplied from the grille 13 to the rack 11 having a small amount of heat generation. In this way, it is possible to achieve an effect similar to that in the case of using the local cooling device.

One conceivable idea for dynamically changing the volume of the air supplied from the grille 13 is to provide each grille 13 with an electric fan. Such a grille 13 provided with the electric fan will be hereinafter referred to as an electric fan-assisted grille. In the air-conditioning control system adopting the electric fan-assisted grilles, the number of revolutions of the electric fan of each grille 13 is controlled depending on the amount of heat generation of the corresponding rack 11, and temperature settings of the air conditioners 15 and the air blow volume therefrom are adjusted depending on an average value of the amounts of heat generated from all the racks 11. Thus, the local insufficient cooling can be avoided while the power required for the air conditioning is reduced.

However, the above-described air-conditioning control system requires a large number of electric fans inside the computer room 10 and causes increases in initial costs as well as maintenance costs. In addition, even when the electric fans are stopped, the low-temperature air passes through the grilles 13 due to a pressure difference between the free access floor 10b and the equipment installation area 10a. For this reason, the low-temperature air is also supplied to the racks 11 not in operation, and the volume of the low-temperature air to be supplied to the racks 11 in operation is decreased accordingly. As a result, the cooling efficiency goes down. Moreover, since the weight is drastically increased when the grilles 13 are respectively provided with the electric fans, a floor reinforcement or earthquake resistant work may be required.

Another conceivable idea is to provide each grille 13 with a louver, and to adjust the volume of the air supplied from the grille 13 to the rack 11 by adjusting an angle of slats of the louver and changing an aperture ratio of the grille 13. Such a grille provided with the louver will be hereinafter referred to as a louver-assisted grille. In the case of the louver-assisted grille, it is possible to achieve weight saving as compared to the electric fan-assisted grille. Hence, the louver-assisted grille does not require a floor reinforcement or earthquake resistant work and can therefore be realized relatively at low costs.

However, in the case of the louver-assisted grille, the aperture ratio is adjusted by means of the angle of the slats, and the angle of the air blowing out of the grille 13 therefore varies depending on the aperture ratio. In other words, when the aperture ratio of the grille 13 is low, the low-temperature air is supplied preferentially to a computer 16 located in a low position of the rack 11 whereas the volume of the low-temperature air to be supplied to a computer 16 located in a high position is reduced.

Now, the embodiments will be described below with reference to the accompanying drawings.

### (Air Volume Adjustment Device)

Fig. 4 and Fig. 5 are perspective views (schematic diagrams) exemplifying an air volume adjustment device according to an embodiment. Note that the following description will also refer to Fig. 1 and Fig. 2 exemplifying the layout inside the computer room 10 and to Fig. 3 exemplifying the computers 16 housed in the rack 11.

An air volume adjustment device 20 according to the embodiment is located below grille plates 31 as in Fig. 5. Meanwhile, the air volume adjustment device 20 according to the embodiment includes a delivery roll 21a, a wind-up roll 21b, and an air volume adjustment sheet 22.

Each grille plate 31 is located above a vent (a grille 13) provided in the floor of the equipment installation area 10a, and is provided with a plurality of venting holes 31a which allow passage of the air supplied from the free access floor 10b to the rack installation area 10a. The grille plate 31 has a withstand load which is enough for avoiding a breakage when a person steps thereon at the time of maintenance.

The delivery roll 21a is located along a side of the vent (the grille 13) near the rack 11, for example, while the wind-up roll 21b is located along the opposite side of the side where the delivery roll 21a is located. The delivery roll 21a has both ends supported by a bearing guide 23a and is rotated by a motor 24a. Meanwhile, the wind-up roll 21b has both ends supported by a bearing guide 23b and is rotated by a motor 24b.

The air volume adjustment sheet 22 is made of a thick resin film, fabric or the like, and is extended from the delivery roll 21a to the wind-up roll 21b. The air volume adjustment sheet 22 is provided with openings 27 which allow passage of the air. In this embodiment, a plurality of opening patterns (openings) 27a, 27b, 27c, ... having different shapes from one another are provided in a longitudinal direction of the air volume adjustment sheet 22 as exemplified in a development view of Fig. 6. The air volume adjustment sheet 22 is delivered from the delivery roll 21a and is rolled up around the wind-up roll 21b by the rotation of the motor 24b, and is reeled out from the wind-up roll 21b and is rolled up around the delivery roll 21a by the rotation of the motor 24a.

Note that Fig. 7 is a view exemplifying an air volume adjustment sheet 22 provided with opening patterns 27d, 27e, 27f having different shapes from the opening patterns 27a, 27b, 27c illustrated in Fig. 6. The shapes of the opening patterns on the air volume adjustment sheet 22 may be set as appropriate depending on operating conditions of the computers. In the meantime, sheet guides holding two sides in a width direction of the air volume adjustment sheet 22, for example, may be provided in order to prevent undulation of the air volume adjustment sheet 22 attributed to the flow of the air and thereby to achieve smooth movement of the air volume adjustment sheet 22.

As in Fig. 4, position control markers 25 are provided to one edge portion in the width direction of the air volume adjustment sheet 22, and a marker reading sensor 26 is located in the vicinity of the bearing guide 23a. In this embodiment, a plurality of holes are provided as the markers 25 at the edge portion of the air volume adjustment sheet 22. The marker reading sensor 26 is connected to a driving unit 44 to be described later, and outputs a given signal to the driving unit 44 upon detection of the markers 25. The driving unit 44 controls drive of the motors 24a, 24b on the basis of this signal. Thus, a predetermined portion of the air volume adjustment sheet 22 can be located between the delivery roll 21a and the wind-up roll 21b. Here, bar codes, QR codes, and the like may also be used as the markers 25.

### (First Air-conditioning Control System)

Fig. 8 is a schematic diagram exemplifying a first air-conditioning control system using the above-described air volume adjustment device. As in Fig. 8, the first air-conditioning control system includes the air conditioner 15, the air volume adjustment device 20, a temperature distribution measurement unit 42 to which an optical fiber 41 serving as a temperature sensor is connected, a control unit 43, and the driving unit 44.

The optical fiber 41 is laid in such a manner as to pass through the intake surface and the exhaust surface of each of the racks 11, and to pass through the free access floor between one rack 11 and another rack 11. The temperature distribution measurement unit 42 is configured to measure temperature distribution of the intake surfaces and the exhaust surfaces of the racks 11, where the optical fiber 41 is laid, by detecting Raman scattered light generated when light (a laser beam) passes through the optical fiber 41.

Here, the optical fiber 41 is used as the temperature sensor. Instead, a thermocouple, a thermistor, an IC-type temperature sensor or the like may be located as the temperature sensor at each of the racks 11. Alternatively, a temperature sensor embedded in a CPU or any other semiconductor chip in the computer 16 may be used.

The control unit 43 outputs control signals respectively to the driving unit 44 and the air conditioner 15 on the basis of temperature distribution data inputted from the temperature distribution measurement unit 42.

The air conditioner 15 is configured to adjust the air blow volume and the temperature setting in accordance with the control signal outputted from the control unit 43. Meanwhile, the driving unit 44 is configured to control the air volume adjustment device 20 (the motors 24a, 24b) in accordance with the control signal outputted from the control unit 43 and outputs from the marker reading sensors 26 (see Fig. 4), and to adjust the aperture ratios of the grilles 13.

Now, an example of operations of the above-described air-conditioning control system will be described with reference to a system configuration diagram of Fig. 8 and a flowchart of Fig. 9. Here, in order to simplify description, four racks 11a to 11d are assumed to be installed in the computer room 10 as in Fig. 10, and grilles 13a to 13d are assumed to be provided on the floor on the intake surface side of the racks 11a to 11d.

In addition, for the convenience of description, the aperture ratio of each of the grilles 13a to 13d is assumed to be defined herein by the area of an overlapping portion between the grille plate 31 and the opening 27 of the air volume adjustment sheet 22. Specifically, a case where the grille plate 31 completely overlaps the opening 27 of the air volume adjustment sheet 22 is defined as the aperture ratio of 100% while a case where the grille plate 31 does not overlap the opening 27 of the air volume adjustment sheet 22 at all is defined as the aperture ratio of 0%.

Moreover, the air volume adjustment sheet 22 is assumed to be provided with the opening patterns 27a, 27b, 27c, ... having the shapes as in Fig. 6. Furthermore, the control unit 43 is assumed to control the air blow volume of the air conditioner 15 based on an average aperture ratio among the grilles 13a to 13d. For example, the control unit 43 sets the air blow volume of the air conditioner 15 as level 1 (the weakest) when the average aperture ratio among the grilles 13a to 13d is 0% to 10%, sets the air blow volume of the air conditioner 15 as level 2 when the average aperture ratio among the grilles 13a to 13d is 10% to 20%, ..., and sets the air blow volume of the air conditioner 15 as level 10 (the strongest) when the average aperture ratio among the grilles 13a to 13d is 90% to 100%.

First, in step S11, the control unit 43 acquires a result of temperature distribution measurement of the racks 11a to 11d from the temperature distribution measurement unit 42. Thereafter, the process goes to step S12 where the control unit 43 determines the aperture ratios of the grilles 13a to 13d and the opening pattern of the air volume adjustment sheet 22 on the basis of the result of the temperature distribution measurement of the racks 11a to 11d.

Next, the process goes to step S13 where the control unit 43 controls the driving unit 44 on the basis of the aperture ratios of the grilles 13a to 13d and the opening pattern of the air volume adjustment sheet 22 determined in step S12 in such a way that the driving unit 44 drives the air volume adjustment device 20 and adjusts the aperture ratios of the grilles 13a to 13d. Meanwhile, the control unit 43 determines the air blow volume of the air conditioner 15 on the basis of the average aperture ratio among the grilles 13a to 13d, and performs control such that the air conditioner 15 blows air at the determined volume.

Next, the process goes to step S14 where the control unit 43 acquires a result of temperature distribution measurement of the racks 11a to 11d from the temperature distribution measurement unit 42. Then, the process goes to step S15 where the control unit 43 judges whether or not the temperature (such as the highest temperature) of each of the racks 11a to 11d is within an appropriate range. Here, the process returns to step S11 and continues when it is judged that the temperatures of the racks 11a to 11d are within the appropriate range.

On the other hand, if the temperature of any of the racks 11a to 11d is out of the appropriate range, the process goes to step S16 where the temperature setting of the air conditioner 15 is changed. Then, the process returns to step S11 and continues.

In Fig. 10(a), the computers 16 in the two racks 11a, 11b on the left side are assumed to be processing relatively light load jobs while the computers 16 in the two racks 11c, 11d on the right side are assumed to be in a non-operating state. Moreover, the control unit 43 is assumed to have determined the aperture ratios of the grilles 13a, 13b in front of the racks 11a, 11b to be set to 20% and the aperture ratios of the grilles 13c, 13d in front of the racks 11c, 11d to be set to 0% on the basis of the temperature distribution of the racks 11a to 11d. In addition, the control unit 43 is assumed to have determined the opening pattern 27b as the opening pattern of the air volume adjustment sheet 22, and the air blow volume of the air conditioner 15 to be set to level 2 on the basis of the aperture ratios of the grilles 13a to 13d.

The control unit 43 controls the air volume adjustment device 20 and the air conditioner 15 in accordance with the aperture ratios, the opening pattern, and the air blow volume thus determined.

In Fig. 10(b), the computers 16 in the two racks 11a, 11b on the left side are assumed to be processing heavy load jobs while the computers 16 in the two racks 11c, 11d on the right side are assumed to be processing relatively light load jobs. Moreover, the control unit 43 is assumed to have determined the aperture ratios of the grilles 13a, 13b in front of the racks 11a, 11b to be set to 100% and the aperture ratios of the grilles 13c, 13d in front of the racks 11c, 11d to be set to 20% on the basis of the temperature distribution of the racks 11a to 11d. In addition, the control unit 43 is assumed to have determined the opening pattern 27b as the opening pattern of the air volume adjustment sheet 22, and the air blow volume of the air conditioner 15 to be set to level 6 on the basis of the aperture ratios of the grilles 13a to 13d.

The control unit 43 controls the air volume adjustment device 20 and the air conditioner 15 in accordance with the aperture ratios, the opening pattern, and the air blow volume thus determined.

In Fig. 10(c), loads of jobs being processed by the computers 16 in the racks are assumed to be heavier in order of the rack 11a, the rack 11b, the rack 11c, and the rack 11d. Moreover, the control unit 43 is assumed to have determined the aperture ratio of the grille 13a to be set to 88%, the aperture ratio of the grille 13b to be set to 63%, the aperture ratio of the grille 13c to be set to 38%, and the aperture ratio of the grille 13d to be set to 13% on the basis of the temperature distribution of the racks 11a to 11d. In addition, the control unit 43 is assumed to have determined the opening pattern 27c as the opening pattern of the air volume adjustment sheet 22, and the air blow volume of the air conditioner 15 to be set to level 6 on the basis of the aperture ratios of the grilles 13a to 13c.

The control unit 43 controls the air volume adjustment device 20 and the air conditioner 15 in accordance with the aperture ratios, the opening pattern portion, and the air blow volume thus determined.

In the above-described examples, the aperture ratios of the grilles 13, the opening pattern of the air volume adjustment sheet 22, and the air blow volume of the air conditioner 15 are set on the basis of the result of temperature distribution measurement of the racks 11. Instead, a job to be submitted to a computer 16 (or the amount of heat generated by a CPU as a consequence of processing such a job) may be associated (developed into a pattern) with a grille aperture ratio, an opening pattern of the air volume adjustment sheet 22, and an air blow volume of the air conditioner 15 in advance. In this case, there is an advantage that once the job to be submitted to the computer 16 is decided, the grille aperture ratio, the opening pattern of the air volume adjustment sheet 22, and the air blow volume of the air conditioner 15 are uniquely determined whereby the control is facilitated.

Fig. 11 is a schematic diagram illustrating a flow of the air from the grille 13 to the rack 11. In the air volume adjustment device 20 of the embodiment, the low-temperature air is supplied from the free access floor 10b to the intake surface side (the cold aisle) of the rack 11 via the opening 27 of the air volume adjustment sheet 22 as in Fig. 11.

In this case, unlike the aforementioned louver-assisted grille, the low-temperature air is sent out of the grille 3 substantially in the vertical direction irrespective of the aperture ratio of the grille 13 in the air volume adjustment device 20 according to the embodiment. As a consequence, the low-temperature air is supplied almost evenly to the entire intake surface of the rack 11 irrespective of the aperture ratio of the grille 13.

In addition, the air volume adjustment device 20 according to the embodiment has a relatively simple structure and can save the weight as compared to the aforementioned electric fan-assisted grille. Therefore, a floor reinforcement or earthquake resistant work is not necessary. Moreover, since the air volume adjustment device 20 according to the embodiment has the relatively simple structure, manufacturing costs are low and maintenance is easy. Furthermore, the air volume adjustment device 20 according to the embodiment can set the aperture ratio of the grille equal to 0% (which means fully closed) unlike the electric fan-assisted grille.

In addition, in case of an emergency where the motors 24a, 24b break down in the state of the grille aperture ratio of 0%, for example, the air volume adjustment device 20 according to the embodiment can supply the low-temperature air to the computers 16 in the rack 11 by cutting out the air volume adjustment sheet 22 with a knife or the like. Thus, it is possible to avoid failures of the computers 16 attributed to insufficient cooling.

Although the delivery roll 21a is driven by the motor 24a in this embodiment, it may be also possible to use a spring instead of the motor 24a and to provide a torque to the delivery roll 21a by using the force of this spring. In this case, it is preferable to provide a mechanism configured to latch the wind-up roll 21b such that the air volume adjustment sheet 22 is rolled up around the delivery roll 21a and the aperture ratio of the grille 13 becomes equal to 100% when a latch is released. Thus, in case of an emergency such as a breakdown of the motor 24b, it is possible to supply the low-temperature air to the computers 16 in the rack 11 by releasing the latch and thereby to avoid failures of the computers 16 attributed to insufficient cooling.

In the meantime, if a flow rate of the air blowing out of the grille 13 changes in association with a change in the aperture ratio of the grille 13, cooling efficiency of the computers 16 in the rack 11 fluctuates as a consequence. For example, assuming that the air blow volume of the air conditioner 15 is constant, the flow rate of the air blowing out of the grille 13 is increased when the aperture ratio of the grille 13 is small, and the cooling efficiency becomes higher at a computer 16 located on an upper side of the rack 11 than a computer 16 located on a lower side thereof. On the other hand, the flow rate of the air blowing out of the grille 13 is decreased when the aperture ratio of the grille 13 is large, and the cooling efficiency becomes lower at the computer 16 located on the upper side of the rack 11 than the computer 16 located on the lower side thereof.

In this regard, it is preferable to adjust the air blow volume of the air conditioner 15 to avoid a change in the flow rate of the air blowing out of the grille 13 even when the aperture ratio of the grille 13 is changed. A way of such control will be described below.

Fig. 12 is a view illustrating a simulation result of relations between aperture ratios of the grilles and volumes of the air blowing out of the grilles. It is to be noted that, as in Fig. 13, assumptions are made herein that four rows of racks 11 are arranged in the computer room, and fourteen grilles 13 denoted by grille No. (1) to grille No. (14), respectively, are installed on the floor on the intake surface side of each row of the racks and along the row of the racks. The size of each grille 13 is assumed to be 50 cm × 50 cm. The aperture ratio of each of seven grilles 13 (grille Nos. (1) to (7)) located on the row of a simulation target (which is the second row from the right in Fig. 13) near an air conditioner 15 is set equal to any of 0% (an opening width of 0 cm), 30% (an opening width of 15 cm), 70% (an opening width of 35 cm), and 100% (an opening width of 50 cm), while the aperture ratio of the rest of the grilles 13 is constantly set equal to 100%.

Fig. 12 indicates that the air volume changes almost in proportion to the aperture ratio when the air blow volume of the air conditioner 15 is adjusted in such a way that the volume of the air blowing out of grille 13 having the aperture ratio of 100% is a specified volume. In other words, when the air blow volume of the air conditioner 15 is adjusted in such a way that the volume of the air blowing out of the grille 13 having the aperture ratio of 100% is the specified volume, the flow rates of the air blowing out of the grilles 13 are almost equal to each other irrespective of the aperture ratios of the grilles 13.

Here, it is preferable that the volumes of the air blowing out of grilles 13 be equal if the grilles 13 have the same aperture ratio. Nevertheless, in reality, the air blow volumes fluctuate between a grille 13 located near the air conditioner 15 and a grille 13 located away from the air conditioner 15 as in Fig. 12. In this regard, the aperture ratios of the grilles 13 may be corrected depending on distances from the air conditioner 15.

### (Another Example of Opening Pattern on Air Volume Adjustment Sheet)

Fig. 14(a) is a perspective view explaining another example of an opening pattern provided to the air volume adjustment sheet 22, and Fig. 14(b) is a schematic diagram illustrating a state where the air volume adjustment sheet 22 is located near a grille.

In this opening pattern 27x, each fin 22a is formed on the air volume adjustment sheet 22 by providing a slit therein in such a manner as to leave just one side of a quadrangle intact. Then, a plurality of fins 22a (three in Fig. 14) thus formed are arranged in a longitudinal direction of the air volume adjustment sheet 22 (a traveling direction of the air volume adjustment sheet 22). The fins 22a are tilted (inclined) by a pressure of the air passing through the grille 13 while using portions connected to the air volume adjustment sheet 22 as supporting points. In the example of Figs. 14(a) and 14(b), rod-shaped members 22b having rigidity are placed at the portions where the fins 22a are connected to the air volume adjustment sheet 22 so as to avoid flapping of the air volume adjustment sheet 22.

In the grille 13 provided with the above-described opening pattern 27x, the air from the free access floor flows in an oblique direction along the fins 22a. As a consequence, the low-temperature air is supplied preferentially to computers housed on the lower side of the rack 11. In this regard, the computers 16 and the air conditioners 15 can be efficiently operated by setting a virtual machine deployment policy according to this situation in such a way that virtual machines are loaded preferentially to the computers 16 housed on the lower side of the rack 11 and that jobs are submitted to these virtual machines.

Note that this opening pattern 27x can be provided to the air volume adjustment sheet 22 together with the other opening patterns. Meanwhile, an inclination angle regulation member configured to regulate an inclination angle of the fin 22a may be provided in order to cause the air to blow out of the grille 13 at a predetermined angle.

### (Second Air-conditioning Control System)

Fig. 15 is a schematic diagram exemplifying a second air-conditioning control system.

Here, an example of an application to air conditioning of a data center employing VM consolidation/deployment techniques will be described. In Fig. 15, the same constituents as those in Fig. 8 will be denoted by the same reference numerals and detailed description thereof will be omitted. Note that shaded portions in Fig. 15 schematically illustrate CPU utilizations of the computers 16 in the racks 11. A shaded portion having a greater height indicates a higher CPU utilization of the computers 16 in the rack 11.

As in Fig. 15, the air-conditioning control system according to the embodiment includes the air conditioner 15, air volume adjustment devices 20a to 20c, the temperature distribution measurement unit 42, the control unit 43, the driving unit 44, and a VM management server 45. An optical fiber (not illustrated) serving as the temperature sensor is connected to the temperature distribution measurement unit 42. The optical fiber is laid in such a manner as to pass through the intake surface and the exhaust surface of each rack 11. As in Fig. 3, the plurality of computers 16 (the physical servers) are housed in each rack 11.

The VM management server 45 acquires data indicating operating conditions from the computers 16 in the racks 11, such as data on CPU utilizations, CPU temperatures, and memory temperatures. Then, based on the data, the VM management server 45 deploys virtual machines in the computers 16 in the racks 11 and determines jobs to be submitted to the virtual machines.

In this case, the VM management server 45 deploys the virtual machines on the basis of a predetermined policy. For example, the VM management server 45 consolidates the virtual machines to the computers 16 in a specific rack 11 so as to set the CPU utilizations of the computers 16 housed in this rack 11 within a range of 50% to 80%, and turns off the computers 16 which are set to an idle state by this consolidation. In the example of Fig. 15, the VM management server 45 turns off the computers 16 in the racks 11 having rack Nos. (1) and (2), and consolidates the virtual machines into the computers 16 in the racks 11 having rack Nos. (3) to (8) and submits the jobs thereto.

Meanwhile, upon determination of the deployment of the virtual machines and the computers 16 to which the jobs are submitted, the VM management server 45 outputs corresponding data to the control unit 43. At the same time, the VM management server 45 predicts the CPU utilizations, the CPU temperatures, and the memory temperatures of the computers 16 after the jobs are submitted thereto, and outputs the predicted results to the control unit 43 as well.

The control unit 43 controls the driving unit 44 and the air conditioner 15 based on the data and the predicted results acquired from the VM management server 45. The driving unit 44 controls the air volume adjustment devices 20a to 20c based on a signal outputted from the control unit 43, and adjusts the aperture ratios of the grilles. Meanwhile, the air conditioner 15 adjusts the air blow volume and the temperature setting based on a signal outputted from the control unit 43.

After controlling the air volume adjustment devices 20a to 20c and the air conditioner 15 based on the data acquired from the VM management server 45 as described above, the control unit 43 acquires data on temperature distribution of the racks 11 from the temperature distribution measurement unit 42, and then judges whether or not the temperature (such as the highest temperature) of each of the computers 16 is within an appropriate range. In consequence, if there is a computer 16 which does not satisfy the appropriate range, the control unit 43 adjusts the grille aperture ratio by means of the driving unit 44, or adjusts any of the air blow volume and the temperature setting of the air conditioner 15.

In the first air-conditioning control system (see Fig. 8), the change in temperature of the computer 16 is first detected by the temperature distribution measurement unit 42, and then the grille aperture ratio, the air blow volume and the temperature setting of the air conditioner 15 are changed by the control unit 43. In contrast, in the second air-conditioning control system, the grille aperture ratio, the air blow volume and the temperature setting of the air conditioner 15 are changed by the control unit 43 either before the jobs are submitted from the VM management server 45 to the computers 16 or substantially at the same time as the submission of the jobs. In this way, it is possible to more reliably prevent the computers 16 from overheating, and thereby to perform efficient air-conditioning control.

Here, data on the grille aperture ratios, the air blow volumes and the temperature setting of the air conditioner 15, and the temperature distribution of the racks 11 in the past may be accumulated in the control unit 43. In this case, for example, the control unit 43 controls the grille aperture ratios and the air conditioner 15 based on the data transmitted from the VM management server 45 and on the accumulated data. Thus, it is possible to perform even more efficient air-conditioning control.

In the meantime, in Fig. 15, the three air volume adjustment devices 20a to 20c are provided to the eight racks 11 (rack Nos. (1) to (8)) arranged in a row. Here, boundaries between the racks 11 are not aligned with boundaries between the air volume adjustment devices 20a to 20c. Specifically, the boundary between the air volume adjustment device 20a and the air volume adjustment device 20b is located in front of the rack 11 in rack No. (3) and the boundary between the air volume adjustment device 20b and the air volume adjustment device 20c is located in front of the rack 11 in rack No. (6) . This is because positions to lay out the air volume adjustment devices 20a to 20c are presumably restricted by posts and the like provided in the free access floor. If there are not such restrictions, then it is of course possible to align the boundaries between the racks 11 with the boundaries between the air volume adjustment devices 20a to 20c.

In the example of Fig. 15, both of the air volume adjustment devices 20a, 20b are located in front of the rack 11 in rack No. (3). However, percentage of contribution of the air volume adjustment device 20b to the cooling of the rack 11 in rack No. (3) is small (below 30%, for example) and is therefore negligible. Accordingly, the result of temperature distribution measurement of rack No. (3) is assumed to be used solely for controlling the air volume adjustment device 20a in this case.

Meanwhile, both of the air volume adjustment devices 20b, 20c are located in front of the rack 11 in rack No. (6). Percentage of contribution of the air volume adjustment devices 20b, 20c to the cooling of the rack 11 in rack No. (6) is relatively large (equal to or above 30%, for example) and is therefore not negligible. Accordingly, the result of temperature distribution measurement of rack No. (6) is assumed to be used for controlling the air volume adjustment devices 20b, 20c in this case.

If the VM management server 45 determines the deployment of the virtual machines based only on the operating conditions (such as the CPU utilizations) of the computers 16, then it is difficult to cool the racks 11 always in the optimum conditions because there is a limit to the number of opening patterns which can be provided to the air volume adjustment sheet 22. Accordingly, it is preferable to provide a restriction on the deployment of the virtual machines by the VM management server 45 in advance. For example, the virtual machines are deployed in two or more racks 11 to be cooled by the same air volume adjustment device in such a manner that the operating conditions of the computers 16 in these racks 11 are substantially the same. Thus, it is possible to reduce the number of the opening patterns on the air volume adjustment sheet 22.

Moreover, in the example of Fig. 15, the boundary between the air volume adjustment devices 20b, 20c are located in front of the rack 11 in rack No. (6). For this reason, it is conceivable that the volume of the low-temperature air supplied to the rack 11 in rack No. (6) via the grille 13 is smaller than the volumes of the low-temperature air supplied to the other racks 11. In such a case as well, a conceivable idea is to provide a restriction on the deployment of the virtual machines by the VM management server 45 in such a manner as to reduce the number of virtual machines loadable in the rack 11 having rack No. (6) as compared to the other racks.

The virtual machine deployment policy can be modified by software. Even more efficient air conditioning can be performed by creating the virtual machine deployment policies depending on the opening patterns of the air volume adjustment sheet 22. Thus, it is possible to further reduce power consumption in the data center.

Here, it may be configured so that the VM management server 45 acquires information on power consumption by each of the racks, and the control unit 43 calculates ratios of the power consumption between mutually adjacent pairs of the plurality of racks 11 based on the information and controls the air volume adjustment devices 20a, 20b, 20c located in front of the racks 11 in accordance therewith. Efficient cooling can be achieved in this case as well.

Meanwhile, the above-described embodiments have explained the case where the air conditioner is controlled by the control unit. Instead, the air conditioner may be operated independently from the control unit. For example, it may be configured so that the air conditioner is operated autonomously under preset conditions and the control unit controls the air volume adjustment devices in accordance with a signal from any of the temperature distribution measurement, the VM management server, and the like.

## Claims

1. An air-conditioning control system for computer rooms, the system comprising:
a rack (11) housing a plurality of computers (16) ;
an equipment installation area (10a) where the rack (11) is installed;
a free access floor (10b) provided under a floor of the equipment installation area (10a);
an air conditioner (15) configured to take in air from the equipment installation area (10a) and to supply the air at adjusted temperature to the free access floor (10b);
a vent (13) connecting the equipment installation area (10a) to the free access floor (10b) ;
an air volume adjustment device (20) located at the vent (13) and configured to adjust a volume of air flowing from the free access floor (10b) to the equipment installation area (10a);
a driving unit (44) configured to drive the air volume adjustment device (20); and
a control unit (43) configured to control the driving unit (44), **characterized in that** the air volume adjustment device (20) comprises:
an air volume adjustment sheet (22) provided with an opening (27) to allow passage of air;
a first roll (21a) connected to one end portion of the air volume adjustment sheet (22) and made capable of reeling in the air volume adjustment sheet (22); and
a second roll (21b) located away from the first roll (21a), connected to another end portion of the air volume adjustment sheet (22), and made capable of reeling in the air volume adjustment sheet (22).

2. The air-conditioning control system of claim 1, **characterized in that**
the system further comprises a temperature measurement unit (42) configured to measure a temperature of the rack (11), and
the control unit (43) is configured to control the driving unit (44) on the basis of a result of temperature measurement performed by the temperature measurement unit (42).

3. The air-conditioning control system of claim 2, **characterized in that** the temperature measurement unit (42) is configured to measure the temperature of the rack (11) by using an optical fiber (41) as a temperature sensor.

4. The air-conditioning control system of any one of claims 1 to 3, **characterized in that** the air volume adjustment sheet (22) is provided with a plurality of the openings (27a to 27c, 27d to 27f) in different shapes arranged in a longitudinal direction of the sheet (22).

5. The air-conditioning control system of claim 4, **characterized in that** at least one of the plurality of openings (27x) provided to the air volume adjustment sheet (22) includes a fin (22a) having an inclination angle varied by passage of the air.

6. The air-conditioning control system of any one of claims 1 to 5, **characterized in that**
the system further comprises a management computer (45) configured to manage operating conditions of the computers (16) housed in the rack (11), and
the control unit (43) is configured to acquire an information on the operating conditions of the computers (16) from the management computer (45) and control the driving unit (44) on the basis of the information on the operating conditions of the computers (16).

7. The air-conditioning control system of claim 6, **characterized in that**
the management computer (45) is configured to determine which computer to submit a job to depending on a shape of the opening of the air volume adjustment sheet (22), or
the control unit (43) is configured to acquire information on power consumption by a plurality of the racks (11) from the management computer (45), control the driving unit (44) based on a ratio of the power consumption among the racks (11), and thereby adjust an aperture ratio of the air volume adjustment device (20a to 20c) located in front of the racks (11).

8. The air-conditioning control system of any one of claims 1 to 7, **characterized in that**
the air volume adjustment sheet (22) is provided with a position control marker (25),
the driving unit (44) is configured to control the air volume adjustment device (20) based on a result of detection of the position control marker (25) in such a way that a predetermined portion of the air volume adjustment sheet (22) is located between the first roll (21a) and the second roll (21b) .

9. The air-conditioning control system of any one of claims 1 to 8, **characterized in that** the control unit (43) is configured to control an air blow volume of the air conditioner (15) depending on the aperture ratio determined by a size of the opening (27) located between the first roll (21a) and the second roll (21b).

10. The air-conditioning control system of claim 9, **characterized in that** the control unit (43) is configured to control the air blow volume of the air conditioner (15) in such a way that a volume of air blowing out of the vent (13) having the largest aperture ratio out of a plurality of the vents (13) is a specified volume.

11. The air-conditioning control system of any one of claims 1 to 10, **characterized in that** the single air volume adjustment device (20, 20a to 20c) is provided with respect to a plurality of the racks (11) .

## Patentansprüche

1. Klimatisierungs-Steuersystem für Rechnerräume, das System umfassend:
ein Rack (11), das mehrere Rechner (16) aufnimmt;
einen Ausrüstungs-Aufstellungsbereich (10a), wo das Rack (11) aufgestellt ist;
einen frei zugänglichen Boden (10b), der unter einem Boden des Ausrüstungs-Aufstellungsbereich (10a) vorgesehen ist;
eine Klimaanlage (15) die ausgelegt ist, Luft aus dem Ausrüstungs-Aufstellungsbereich (10a) aufzunehmen und die Luft bei angepasster Temperatur dem frei zugänglichen Boden (10b) zuzuführen;
eine Entlüftung (13), die den Ausrüstungs-Aufstellungsbereich (10a) mit dem frei zugänglichen Boden (10b) verbindet;
eine Luftvolumen-Anpassungsvorrichtung (20), die an der Entlüftung (13 befindlich ist und ausgelegt ist, ein Volumen von Luft anzupassen, die aus dem frei zugänglichen Boden (10b) zu dem Ausrüstungs-Aufstellungsbereich (10a) strömt.
eine Antriebseinheit (44), die ausgelegt ist, die Luftvolumen-Anpassungsvorrichtung (20) anzutreiben; und
eine Steuereinheit (43), die ausgelegt ist, die Antriebseinheit (44) zu steuern, **dadurch gekennzeichnet, dass**
die Luftvolumen-Anpassungsvorrichtung (20) Folgendes umfasst:
eine Bahn (22) zur Anpassung des Luftvolumens, die mit einer Öffnung (27) versehen ist, um einen Durchtritt von Luft zu erlauben;
eine erste Rolle (21a), die mit einem Endabschnitt der Bahn (22) zur Anpassung des Luftvolumens verbunden ist und in die Lage versetzt ist, die Bahn (22) zur Anpassung des Luftvolumens einzurollen; und
eine zweite Rolle (21b), die von der ersten Rolle (21a) entfernt befindlich ist, die mit einem anderen Endabschnitt der Bahn (22) zur Anpassung des Luftvolumens verbunden ist und in die Lage versetzt ist, die Bahn (22) zur Anpassung des Luftvolumens einzurollen.

2. Klimatisierungs-Steuersystem nach Anspruch 1, **dadurch gekennzeichnet, dass**
das System ferner eine Temperaturmesseinheit (42) umfasst, die ausgelegt ist, eine Temperatur des Racks (11) zu messen, und
die Steuereinheit (43) ausgelegt ist, die Antriebseinheit (44) anhand eines Ergebnisses der Temperaturmessung zu steuern, die von der Temperaturmesseinheit (42) ausgeführt wird.

3. Klimatisierungs-Steuersystem nach Anspruch 2, **dadurch gekennzeichnet, dass** die Temperaturmesseinheit (42) ausgelegt ist, die Temperatur des Racks (11) unter Verwendung einer optischen Faser (41) als Temperatursensor zu messen.

4. Klimatisierungs-Steuersystem nach einem der Ansprüche 1 bis 3, **dadurch gekennzeichnet, dass** das Blatt (22) zur Anpassung des Luftvolumens mit mehreren der Öffnungen (27a bis 27c, 27d bis 27f) in verschiedenen Formen versehen ist, die in einer Längsrichtung der Bahn (22) angeordnet sind.

5. Klimatisierungs-Steuersystem nach Anspruch 4, **dadurch gekennzeichnet, dass** mindestens eine der mehreren der Öffnungen (27x), mit denen die Bahn (22) zur Anpassung des Luftvolumens versehen ist, eine Rippe (22a) umfasst, die einen Neigungswinkel aufweist, der durch einen Durchtritt der Luft geändert wird.

6. Klimatisierungs-Steuersystem nach einem der Ansprüche 1 bis 5, **dadurch gekennzeichnet, dass** das System ferner eine Temperaturmesseinheit (45) umfasst, die ausgelegt ist, Betriebsbedingungen der Rechner (16) zu verwalten, die in dem Rack (11) aufgenommen sind, und
die Steuereinheit (43) ausgelegt ist, eine Information über die Betriebsbedingungen der Rechner (16) von dem Verwaltungsrechner (45) zu erlangen und die Antriebseinheit (44) anhand der Information über die Betriebsbedingungen der Rechner (16) zu steuern.

7. Klimatisierungs-Steuersystem nach Anspruch 6, **dadurch gekennzeichnet, dass**
der Verwaltungsrechner (45) ausgelegt ist, in Abhängigkeit von einer Form der Öffnung der Bahn (22) zur Anpassung des Luftvolumens festzustellen, an welchen Rechner ein Auftrag gesandt werden soll, oder
die Steuereinheit (43) ausgelegt ist, von dem Verwaltungsrechner (45) Informationen über Stromverbrauch durch mehrere der Racks (11) zu erlangen, die Antriebseinheit (44) anhand eines Verhältnisses des Stromverbrauchs unter den Racks (11) zu steuern und dadurch ein Öffnungsverhältnis der Luftvolumen-Anpassungsvorrichtung (20a bis 20c) anzupassen, die sich vor den Racks (11) befindet.

8. Klimatisierungs-Steuersystem nach einem der Ansprüche 1 bis 7, **dadurch gekennzeichnet, dass** die Bahn (22) zur Anpassung des Luftvolumens mit einer Positionssteuerungsmarkierung (25) versehen ist,
die Antriebseinheit (44) ausgelegt ist, die Luftvolumen-Anpassungsvorrichtung (20) anhand eines Ergebnisses einer Erkennung der Positionssteuerungsmarkierung (25) derart zu steuern, dass sich ein vorgegebener Abschnitt der Bahn (22) zur Anpassung des Luftvolumens zwischen der ersten Rolle (21a) und der zweiten Rolle (21b) befindet.

9. Klimatisierungs-Steuersystem nach einem der Ansprüche 1 bis 8, **dadurch gekennzeichnet, dass** die Steuereinheit (43) ausgelegt ist, ein Luftblasvolumen der Klimaanlage (15) in Abhängigkeit von dem Öffnungsverhältnis zu steuern, das durch eine Größe der Öffnung (27) festgestellt wird, die sich zwischen der ersten Rolle (21a) und der zweiten Rolle (21b) befindet.

10. Klimatisierungs-Steuersystem nach Anspruch 9, **dadurch gekennzeichnet, dass** die Steuereinheit (43) ausgelegt ist, das Luftblasvolumen der Klimaanlage (15) derart zu steuern, dass ein Volumen von Luft, die aus der Entlüftung (13) mit dem größten Öffnungsverhältnis von mehreren der Entlüftungen (13) herausbläst, ein festgelegtes Volumen ist.

11. Klimatisierungs-Steuersystem nach einem der Ansprüche 1 bis 10, **dadurch gekennzeichnet, dass** die einfache Luftvolumen-Anpassungsvorrichtung (20, 20a bis 20c) mit Bezug auf mehrere der Racks (11) bereitgestellt ist.

## Revendications

1. Système de commande de climatisation destiné à des salles informatiques, le système comprenant :
un rack (11) contenant une pluralité d'ordinateurs (16) ;
une zone d'installation de matériel (10a) dans laquelle le rack (11) est installé ;
un étage en accès libre (10b) prévu sous un étage de la zone d'installation de matériel (10a) ;
un climatiseur (15) configuré pour aspirer l'air de la zone d'installation de matériel (10a) et pour fournir l'air à une température ajustée à l'étage en accès libre (10b) ;
une évacuation (13) reliant la zone d'installation de matériel (10a) à l'étage en accès libre (10b) ;
un dispositif d'ajustement de volume d'air (20) situé au niveau de l'évacuation (13) et configuré pour ajuster un volume d'air qui circule entre l'étage en accès libre (10b) et la zone d'installation de matériel (10a) ;
une unité d'entraînement (44) configurée pour entraîner le dispositif d'ajustement de volume d'air (20) ; et
une unité de commande (43) configurée pour commander l'unité d'entraînement (44), **caractérisé en ce que**
le dispositif d'ajustement de volume d'air (20) comprend :
une plaque d'ajustement de volume d'air (22) munie d'une ouverture (27) afin de permettre le passage de l'air ;
un premier rouleau (21a) relié à une partie d'extrémité de la plaque d'ajustement de volume d'air (22) et capable de tourner dans la plaque d'ajustement de volume d'air (22) ; et
un second rouleau (21b) situé à l'écart du premier rouleau (21a), relié à une autre partie d'extrémité de la plaque d'ajustement de volume d'air (22), et capable de tourner dans la plaque d'ajustement de volume d'air (22).

2. Système de commande de climatisation selon la revendication 1, **caractérisé en ce que**
le système comprend en outre une unité de mesure de la température (42) configurée pour mesurer une température du rack (11), et
l'unité de commande (43) est configurée pour commander l'unité d'entraînement (44) sur la base d'un résultat de la mesure de température effectuée par l'unité de mesure de la température (42).

3. Système de commande de climatisation selon la revendication 2, **caractérisé en ce que** l'unité de mesure de la température (42) est configurée pour mesurer la température du rack (11) en utilisant une fibre optique (41) comme capteur de température.

4. Système de commande de climatisation selon l'une quelconque des revendications 1 à 3, **caractérisé en ce que** la plaque d'ajustement de volume d'air (22) est munie d'une pluralité d'ouvertures (27a à 27c, 27d à 27f) de différentes formes et prévues dans une direction longitudinale de la plaque (22).

5. Système de commande de climatisation selon la revendication 4, **caractérisé en ce qu'**au moins l'une de la pluralité d'ouvertures (27x) prévues sur la plaque d'ajustement de volume d'air (22) comprend une ailette (22a) ayant un angle d'inclinaison qui varie avec le passage de l'air.

6. Système de commande de climatisation selon l'une quelconque des revendications 1 à 5, **caractérisé en ce que** le système comprend en outre un ordinateur de gestion (45) configuré pour gérer les conditions de fonctionnement des ordinateurs (16) contenus dans le rack (11), et
l'unité de commande (43) est configurée pour acquérir une information sur les conditions de fonctionnement des ordinateurs (16) auprès de l'ordinateur de gestion (45) et pour commander l'unité d'entraînement (44) sur la base de l'information sur les conditions de fonctionnement des ordinateurs (16).

7. Système de commande de climatisation selon la revendication 6, **caractérisé en ce que**
l'ordinateur de gestion (45) est configuré pour déterminer l'ordinateur auquel une tâche doit être soumise selon une forme de l'ouverture de la plaque d'ajustement de volume d'air (22), ou
l'unité de commande (43) est configurée pour acquérir des informations sur la consommation d'énergie d'une pluralité des racks (11) auprès de l'ordinateur de gestion (45), pour commander l'unité d'entraînement (44) sur la base d'un rapport de consommation d'énergie parmi les racks (11), et pour ajuster ainsi un rapport d'ouverture du dispositif d'ajustement de volume d'air (20a à 20c) situé en face des racks (11).

8. Système de commande de climatisation selon l'une quelconque des revendications 1 à 7, **caractérisé en ce que**
la plaque d'ajustement de volume d'air (22) est munie d'un repère de contrôle de position (25),
l'unité d'entraînement (44) est configurée pour commander le dispositif d'ajustement de volume d'air (20) sur la base d'un résultat de détection du repère de contrôle de position (25) de sorte qu'une partie prédéterminée de la plaque d'ajustement de volume d'air (22) soit située entre le premier rouleau (21a) et le second rouleau (21b).

9. Système de commande de climatisation selon l'une quelconque des revendications 1 à 8, **caractérisé en ce que** l'unité de commande (43) est configurée pour contrôler un volume de soufflage d'air du climatiseur (15) selon le rapport d'ouverture déterminé par une taille de l'ouverture (27) située entre le premier rouleau (21a) et le second rouleau (21b).

10. Système de commande de climatisation selon la revendication 9, **caractérisé en ce que** l'unité de commande (43) est configurée pour contrôler le volume de soufflage d'air du climatiseur (15) de sorte qu'un volume d'air sortant de l'évacuation (13) présentant le rapport d'ouverture le plus élevé parmi une pluralité des évacuations (13) soit un volume spécifié.

11. Système de commande de climatisation selon l'une quelconque des revendications 1 à 10, **caractérisé en ce que** le dispositif d'ajustement de volume d'air (20, 20a à 20c) est prévu par rapport à une pluralité des racks (11).
